# EUROPEAN PATENT SPECIFICATION

(11) **EP 3 036 819 B1**
(45) Date of publication and mention of the grant of the patent: **05.02.2020**
(21) Application number: 14861103.1
(22) Date of filing: 16.12.2014
(51) Int. Cl.: H02J 7/00

(54) **METHOD AND APPARATUS FOR ADJUSTING VOLTAGE THRESHOLD FOR BATTERY BY MEASURING INTERNAL RESISTANCE OF BATTERY, AND CORRESPONDING METHOD AND SENSOR CIRCUIT FOR MEASURING INTERNAL RESISTANCE OF BATTERY**
VERFAHREN UND VORRICHTUNG ZUR EINSTELLUNG DER SPANNUNGSSCHWELLE EINER BATTERIE DURCH MESSEN DES INNENWIDERSTANDES DER BATTERIE SOWIE ENTSPRECHENDES VERFAHREN UND SENSORSCHALTUNG ZUR MESSUNG DES INNENWIDERSTANDES DER BATTERIE
PROCÉDÉ ET APPAREIL POUR AJUSTER LE SEUIL DE TENSION D'UNE BATTERIE EN MESURANT LA RÉSISTANCE INTERNE DE LA BATTERIE, PROCÉDÉ CORRESPONDANT ET CIRCUIT DE DÉTECTION CORRESPONDANT POUR MESURER LA RÉSISTANCE INTERNE D'UNE BATTERIE

(30) Priority: 17.01.2014 US 201461928809 P
(43) Date of publication of application: 29.06.2016
(73) Proprietor: MediaTek Inc., Hsin-Chu 300, Taiwan (TW)
(72) Inventor: LEE, Chien-Lung, Hsinchu City 300, Taiwan, R.O.C. (TW); HUANG, Chih-Chien, Hsinchu City 300, Taiwan, R.O.C. (TW)
(74) Representative: Hoefer & Partner Patentanwälte mbB
(86) International application number: PCT/CN2014/093950
(87) International publication number: WO 2015/106613

(56) References cited:
- CN-A- 1 845 418
- CN-A- 103 091 636
- US-A- 5 903 136
- US-A1- 2010 127 670

## Description

### TECHNICAL FIELD

The invention relates to a scheme for adjusting a voltage threshold and measuring an internal resistance for a battery, and more particularly to method and apparatus for adjusting the voltage threshold and/or internal resistance for the battery.

### BACKGROUND

Generally speaking, the internal resistance of a battery may be different when the battery is used under different conditions. In addition, different batteries may correspond to different internal resistances. The internal resistance of the battery may cause an internal voltage drop when a current is flowing through the battery. Especially, when a higher charging current is used for charging the battery, the internal voltage drop becomes more significant.

For charging the battery, a conventional charging scheme may include two operation modes: the constant current charging mode and constant voltage charging mode. The internal voltage drop may cause the conventional charging scheme switch from constant current charging mode to constant voltage charging mode too early. It may cause the charging current for the battery smaller and the whole waiting time for charging the battery longer. That is, a conventional protection scheme may too late to sense to protect the battery due to the internal voltage drop. Thus, it is important and necessary to provide a scheme capable of protecting the battery at a correct timing and/or charging the battery rapidly.

US5903136A discloses a method for charging a secondary battery, wherein a charging current is maintained, but the value of the current is changed for a short time, and the internal resistance of the battery is calculated from the voltage and the current before and after the changing of the charging current.

US20100127670A1 discloses a charger including a regulator, a controller and a compensation-adjusting unit for accurately charging a battery device.

### SUMMARY

It is therefore one of the objectives of the invention to provide a scheme for adjusting a voltage threshold for a battery by calculating/deriving the internal resistance of battery, so as to solve the above-mentioned problems.

This is achieved by a method according to claim 1 and an apparatus according to claim 4.

According to an embodiment of the invention, a method for adjusting a voltage threshold for a battery being connected to a portable device is disclosed. The method comprises: dynamically measuring an internal resistance of the battery; and dynamically adjusting the voltage threshold according to the internal resistance of the battery and a current flowing through the battery.

According to an embodiment of the invention, a method for dynamically measuring an internal resistance of a battery being connected to a portable device is disclosed. The method comprises: measuring an external voltage level of the battery for a first time to generate a first result and measuring a charging current to be provided to the battery; measuring the external voltage level for a second time to generate a second result when the charging current is being provided to the battery; and estimating the internal resistance of the battery according to the first result, the second result, and the charging current.

According to an embodiment of the invention, an apparatus for adjusting a voltage threshold for a battery being connected to a portable device is disclosed. The apparatus comprises a sensor circuit and a controller circuit. The sensor circuit is used for dynamically measuring an internal resistance of the battery. The controller circuit is coupled to the sensor circuit and used for dynamically informing a system operating on the portable device to adjust the voltage threshold according to the internal resistance of the battery and a current flowing through the battery.
According to an embodiment of the invention, a sensor circuit for dynamically measuring an internal resistance of a battery being connected to a portable device is disclosed. The sensor circuit comprises a measuring circuit and a calculating circuit. The measuring circuit is used for measuring an external voltage level of the battery for a first time to generate a first result, measuring a charging current to be provided to the battery, and measuring the external voltage level for a second time to generate a second result when the charging current is being provided to the battery. The calculating circuit is coupled to the measuring circuit and used for estimating the internal resistance of the battery according to the first result, the second result, and the charging current.

According to the above embodiments, one of the advantages of the invention is that the apparatus mentioned above can dynamically adjust the maximum voltage threshold and/or the minimum voltage threshold by referring to the internal resistance of the battery so as to avoid malfunction caused by the internal voltage drop to reduce the whole waiting time for charging the battery and precisely protect the battery cell.

These and other objectives of the present invention will no doubt become obvious to those of ordinary skill in the art after reading the following detailed description of the preferred embodiment that is illustrated in the various figures and drawings.

### BRIEF DESCRIPTION OF DRAWINGS

FIG. 1 is a diagram of a sensor circuit according to an embodiment of the invention.
FIG. 2 is a diagram of an apparatus including the sensor circuit as shown in FIG. 1 according to an embodiment of the invention when the battery is being charged.
FIG. 3A is a diagram illustrating an example for charging a battery by a fixed maximum voltage threshold based on a conventional scheme.
FIG. 3B is a diagram illustrating an example of the apparatus as shown in FIG. 2 for adjusting the maximum voltage threshold for the external voltage level of battery according to an embodiment of the invention.
FIG. 4 is a flowchart illustrating the operation of apparatus as shown in FIG. 2.

### DETAILED DESCRIPTION

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

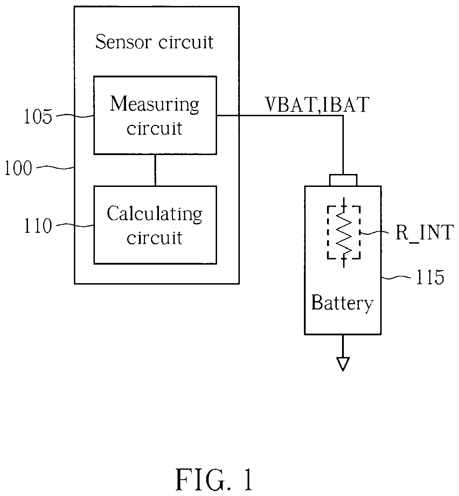

Please refer to FIG. 1, which is a diagram of a sensor circuit 100 according to an embodiment of the invention. The sensor circuit 100 is used for dynamically measuring/sensing an equivalent internal resistance R_INT of a battery 115 being connected to a portable device such as a smart phone device, a tablet device, or a wearable computing device. For instance, the sensor circuit 100 may be installed within a charger device of the portable device. The sensor circuit 100 is capable of sensing internal resistances of different batteries of portable devices which may correspond to different battery types or different operating conditions. The sensing results generated by the sensor circuit 100 can be used in different applications/operations.

In practice, the sensor circuit 100 comprises a measuring circuit 105 and a calculating circuit 110. The measuring circuit 105 is used for measuring or sensing an external voltage level VBAT of battery 115 being connected to the portable device and a current IBAT flowing through the battery 115. For example, the external voltage level VBAT of the battery 115 may comprise an internal voltage drop and an actual voltage level at a battery cell within the battery 115. In addition, the current IBAT flowing through the battery 115 may be a charging current provided for the battery 115 or a current provided by the battery 115. That is, the measuring circuit 105 can measure the charging current provided for the battery 115 (i.e. a current flowing into the battery) or an output current provided by the battery 115 (i.e. a current flowing out from the battery 115). The calculating circuit 110 is used for calculating/deriving the internal resistance of the battery 115 according to the sensed external voltage level VBAT and the sensed current IBAT flowing through the battery 115.

In this embodiment, for example, the current flowing through the battery 115 is the charging current provided for the battery 115. The measuring circuit 105 is arranged for measuring the external voltage level VBAT of the battery 115 when no currents flow into or out from the battery 115 for a first time to generate a first result. In this situation, the sensed voltage level VBAT comprises the actual voltage level at the battery cell within battery 115 and excludes the internal voltage drop since no currents flow through the battery 115. In addition, the measuring circuit 105 is arranged to measure the charging current to be provided to the battery 115. Then, the measuring circuit 105 is arranged for measuring the external voltage level VBAT when the charging current is being provided to the battery 115 for a second time to generate a second result. In this situation, the sensed voltage level VBAT comprises the actual voltage level at the battery cell and the internal voltage drop caused by the charging current. Finally, after the first result and the second result have been generated, the calculating circuit 110 is arranged for estimating/calculating the internal resistance of the battery 115 according to the first result, the second result, and the charging current. The charging current can be a substantially constant current ICC under a constant current charging mode or a varying charging current under a constant voltage charging mode.

In other words, the measuring circuit 105 measures or detects the external voltage level VBAT of the battery 115 twice for generating the first result and the second result. The calculating circuit 110 calculates a voltage difference between two detected voltage levels based on the first and second results. Then, the calculating circuit 110 calculates or derives the internal resistance R_INT based on the voltage difference and the charging current mentioned above. The measurement or detection for the external voltage level VBAT can be dynamically performed or executed by the measuring circuit 105. That is, the measuring circuit 105 can decide when to perform the measurement or detection according to different operation conditions.

Additionally, in another embodiment, the current flowing through the battery 115 may be the output current provided by the battery 115 for the system when the system operating on the portable device is consuming energy of the battery 115. In this situation, the measuring circuit 105 can also be arranged to measure the external voltage level VBAT of battery 115 twice for generating the first and second results, and the calculating circuit 110 can calculate a voltage difference and derive the internal resistance R_INT of battery 115 based on the voltage difference and the output current flowing out from the battery 115. Thus, whether the battery is being charged by an adaptor or is providing energy for the system, the sensor circuit 100 is capable of estimating or tracing the equivalently internal resistance R INT of battery 115.

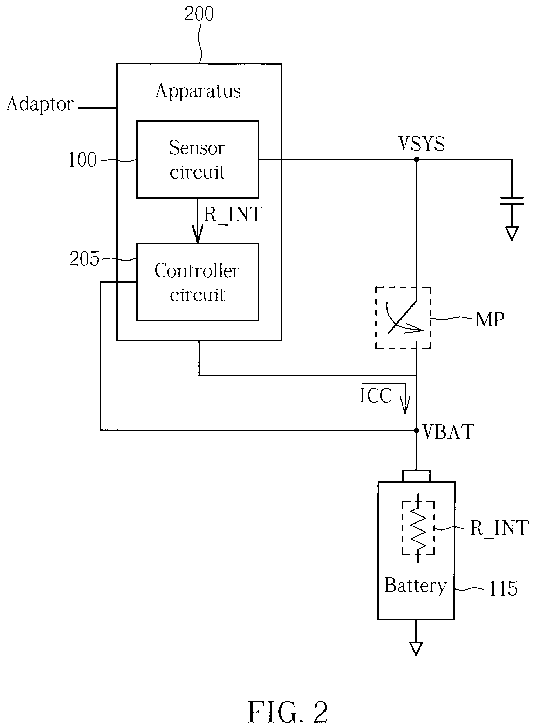

FIG. 2 is a diagram of an apparatus 200 including the sensor circuit 100 as shown in FIG. 1 according to an embodiment of the invention when the battery 115 is being charged. As shown in FIG. 2, the apparatus 200 comprises the sensor circuit 100 and a controller circuit 205. The apparatus 200 for example is a charger device which is connected between an adaptor, the portable device (such as a smart phone device, a tablet device, or a wearable computing device), and the battery 115. In this embodiment, the power path switch MP (may be implemented by a transistor) is connected between the system operating on the portable device and the battery 115. As shown on FIG. 2, the power path switch MP is connected between a system voltage VSYS and external voltage level VBAT of battery 115. The power path switch MP is employed in this embodiment so that the apparatus 200 can estimate the internal resistance R_INT of battery 115. The power path switch MP can be also arranged for making the system operating on the portable device can immediately consume power from an adaptor when the battery 115 is empty and the adaptor is initially connected to the apparatus 200 (i.e. charger device). For example, when the switch MP is open, the system can directly consume the energy of adaptor via the apparatus 200 without via the battery 115.

Specifically, when the apparatus 200 decides to control the sensor circuit 100 to start estimation of the internal resistance R_INT of battery 115, the power path switch MP initially is turned on so that the switch MP is closed, and the apparatus 200 is arranged to provide the charging current ICC for the battery 115 in this situation. This controlling operation may be triggered by the controller circuit 205 of the apparatus 200. The sensor circuit 100 is arranged to measure the external voltage level VBAT for the first time to generate the first result. In this situation, the sensed voltage level VBAT comprises the actual voltage level at the battery cell within the battery 115 but excludes the internal voltage drop since almost no currents flow into or out from the battery 115. In addition, the sensor circuit 100 is arranged to measure the charging current ICC to be provided to the battery 115. For example, the external voltage level measured by the sensor circuit 100 for the first time may be equal to VBAT_INT, and the charging current measured by the sensor circuit 100 may be equal to a substantially constant charging current ICC under the constant current charging mode. Then, the power path switch MP is turned off so that the switch MP becomes open, and the system voltage VSYS and the external voltage level VBAT are disconnected. In this situation, the apparatus 200 is arranged to provide the charging current ICC for charging the battery 115. The sensor circuit 100 is arranged to measure the external voltage level VBAT for the second time to generate the second result. For example, the external voltage level measured by the sensor circuit 100 for the second time may be equal to VBAT1. The voltage level VBAT1 is comprised by the actual voltage level VBAT_INT at the battery cell and the internal voltage drop. In the next step, the sensor circuit 100 calculates the voltage difference between VBAT1 and VBAT_INT and can accurately derive the internal resistance R_INT based on the measured voltage levels VBAT1 and VBAT_INT and the charging current ICC.

In another embodiment, it should be noted that measuring the external voltage level VBAT of batter 115 can be performed or executed twice when the apparatus 200 is providing charging current for charging the battery 115. The internal resistance R_INT of battery 115 can still be effectively estimated or calculated.

After calculating the internal resistance R_INT of battery 115, the controller circuit 205 within the apparatus 200 is arranged to adjust the voltage threshold for the battery 115 according the internal resistance R_INT. In this example, when the battery is being charged, the voltage threshold may indicate a maximum voltage threshold of battery when the battery 115 is being charged. That is, the voltage threshold is a maximum threshold for the external voltage level of battery. For example, the maximum voltage threshold can be configured for the constant current charging mode and/or the constant voltage charging mode. The controller circuit 205 may increase the maximum threshold under the constant current charging mode and dynamically increase/decrease the maximum threshold under the constant voltage charging mode. It should be noted that the adjusted maximum voltage threshold is higher than or equal to an initially configured maximum voltage threshold whether it is under the constant current charging mode or the constant voltage charging mode. This is because the internal resistance of battery causes an actually maximum voltage level at the cell of battery to be lower than the target maximum voltage threshold which may be configured initially. Increasing the maximum voltage threshold for the external voltage level VBAT when the battery is being charged, it can make that the actually maximum voltage level at the battery cell approximate or equal to the target maximum voltage threshold when the battery is full.

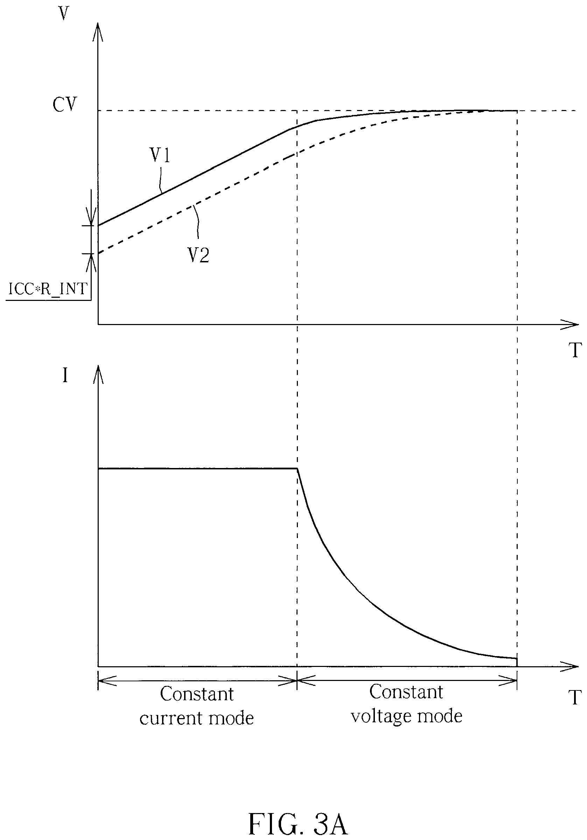

Please refer to FIG. 3A, which illustrates an example for charging a battery by a fixed maximum voltage threshold based on a conventional scheme. As shown in FIG. 3A, CV indicates the constant/fixed maximum voltage threshold; the curve VI indicates the history of external voltage level VBAT, and the curve V2 indicates the history of actually voltage level at the battery cell. The conventional scheme employs a constant current ICC under the constant current charging mode and switches to the constant voltage charging mode when the external voltage level VBAT approaches to the fixed maximum voltage threshold CV. However, when switching to the constant voltage charging mode, the actually voltage level at the battery cell is usually still not close to the fixed maximum voltage threshold CV due to an internal voltage drop ICC×R_INT. The internal voltage drop indicates the voltage difference between the external voltage level and the actually voltage level at the battery cell and is caused by the internal resistance. The conventional scheme decides to switch from the constant current charging mode to the constant voltage charging mode when the external voltage level approaches to the target maximum voltage threshold. Since the actual voltage level at the battery cell is far away from the target maximum voltage threshold, the voltage drop may cause the timing of deciding mode switching occur earlier, and thus a total waiting time for charging the battery becomes longer.

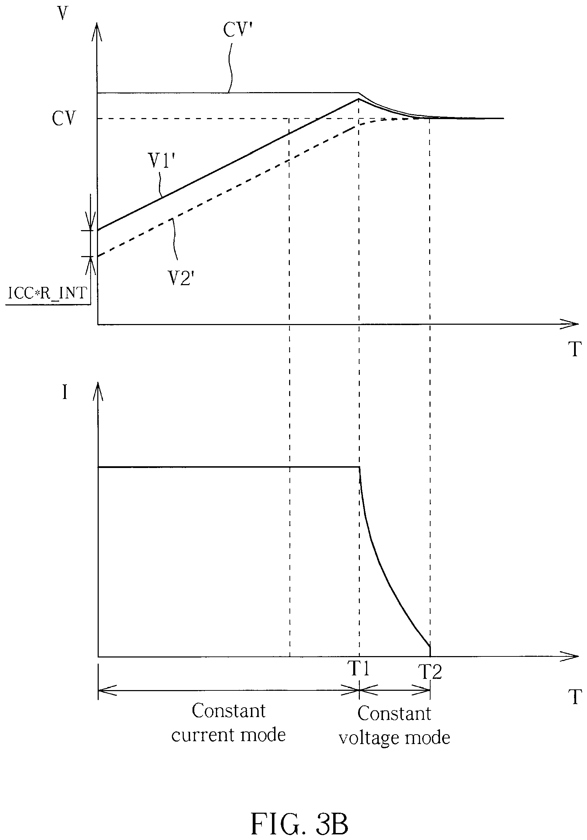

FIG. 3B is a diagram illustrating an example of the apparatus 200 as shown in FIG. 2 for adjusting the maximum voltage threshold for the external voltage level of battery 115 according to an embodiment of the invention. As shown in FIG. 3B, the apparatus 200 is arranged to increase the target maximum voltage threshold from the level CV to the level CV' when the battery 115 is being charged under the constant current charging mode wherein the CV' is equal to the sum of level CV and a multiplication of constant charging current ICC and internal resistance R_INT that has been estimated. That is, the adjusted maximum voltage threshold is higher than the initial maximum voltage threshold. Curve VI' indicates the history of external voltage level VBAT, and curve V2' indicates the history of actually voltage level at the battery cell. ICC×R_INT indicates the internal voltage drop. When the external voltage level of battery 115 reaches the adjusted maximum voltage threshold at time T1, the apparatus 200 decides to switch from the constant current charging mode to the constant voltage charging mode. During the interval between timing T1 and timing T2, the apparatus 200 operates under the constant voltage charging mode, and the charging current is not fixed at the maximum charging current ICC but varies and for example may decrease with time. The apparatus 200 may dynamically detect the internal resistance R_INT and the charging current, and is arranged for dynamically adjusting the target maximum voltage threshold according to the currently detected internal resistance R_INT and charging current. That is, the target maximum voltage threshold in this embodiment is a dynamic level.

In another embodiment, during the interval between timing T1 and timing T2, it may be not required for the apparatus 200 to detect the internal resistance R_INT since the variance of internal resistance R_INT may be small and can be ignored. In this situation, the apparatus 200 merely dynamically or periodically senses the charging current and adjusts the target maximum voltage threshold based on the currently detected charging current the internal resistance R_INT previously detected. In the example of FIG. 3B, by adjusting the target maximum voltage threshold, this can significantly reduce the waiting time for charging the battery 115. In this example, a waiting time corresponding to the constant current charging mode is slightly extended compared to an original waiting time due to that the target maximum voltage threshold is slightly adjusted and raised, and a waiting time corresponding to the constant voltage charging mode is significantly reduced since the battery 115 has been charged with more energy under the longer constant current charging mode and a longer time for the constant voltage charging mode is accordingly not needed. Thus, the whole waiting time for charging the battery 115 becomes shorter, and the apparatus 200 is capable of charging the battery 115 more rapidly or more efficiently. This operation for extending the waiting time associated with the constant current charging mode can be regarded as an operation of compensating for the internal voltage drop caused by the internal resistance R_INT. In addition, by dynamically decreasing the target maximum voltage threshold under the constant voltage charging mode in the example of FIG. 3B, the apparatus 200 can avoid that the battery 115 is overly charged.

In another embodiment, when the battery is being used for providing energy to the system operating on the portable device, the apparatus 200 can be arranged to adjust the target minimum voltage threshold for the system so that the battery can be appropriately protected and the system can consume more power from the battery simultaneously. That is, the battery can be protected and battery life can be extended. For example, the apparatus 200 can detect and calculate the internal resistance R_INT, and then can make the system operating on the portable device adjust or tune the target minimum voltage threshold which is requested by the system itself. After calculating the internal resistance R_INT, the apparatus 200 is arranged for notifying the system of information of the internal resistance R_INT. Thus, the system can adjust or tune the target minimum voltage threshold that has been originally configured so as to generate a new target minimum voltage threshold according to the internal resistance R_INT and the current provided from the battery 115 to the system. The system can also employ software techniques to calculate or derive the new target minimum voltage threshold based on the information of internal resistance R_INT and the current. The apparatus 200 is capable of dynamically making the system raise or lower the minimum voltage threshold so that the battery can be used for providing more energy to the system before the system decides to shut down and the battery can be appropriately protected. For example, if the target minimum voltage threshold is initially configured as 3.4Volts, this indicates that the system may shut down to protect the battery and some circuits if the external battery voltage becomes lower than 3.4Volts. In this situation, if the internal resistance R_INT is smaller (i.e. the battery 115 is employed by a good battery), then the system may slightly lower the target minimum voltage threshold so that more energy of the battery 115 can be provided to the system. For example, a new target minimum voltage threshold may be configured by the system as 3.3Volts. That is, the system may shut down to protect the battery and some circuits only when the external battery voltage becomes lower than 3.3 Volts. Instead, if the internal resistance R_INT is larger (i.e. the battery 115 is employed by a bad battery), then the system may slightly raise the target minimum voltage threshold so that the battery 115 and/or some circuits can be appropriately protected. For example, a new target minimum voltage threshold may be configured by the system as 3.5Volts. That is, the system may shut down to protect the battery and some circuit(s) early once the external battery voltage becomes lower than 3.5Volts. It should be noted that the above-described operations are not meant to be limitations of the invention.

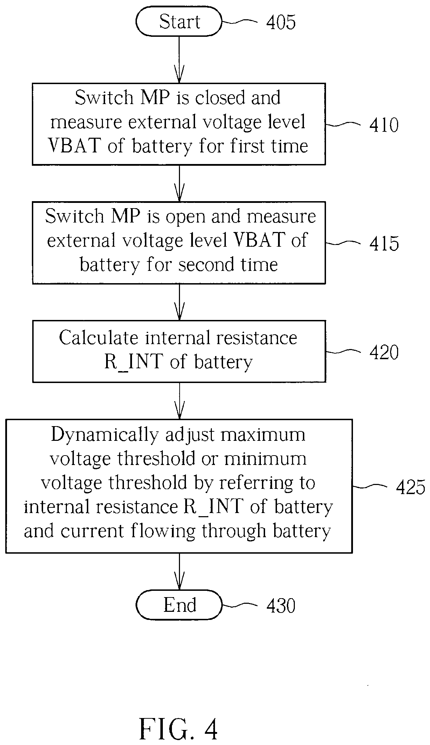

Please refer to FIG. 4, which is a flowchart illustrating the operation of apparatus 200 as shown in FIG. 2. Provided that substantially the same result is achieved, the steps of the flowchart shown in FIG. 4 need not be in the exact order shown and need not be contiguous, that is, other steps can be intermediate. The steps of FIG. 4 are detailed in the following:
Step 405: Start;
Step 410: the switch MP is closed and the sensor circuit 100 is arranged to measure the external voltage level VBAT of battery 115 for the first time;
Step 415: the switch MP is open and the sensor circuit 100 is arranged to measure the external voltage level VBAT of battery 115 for the second time when the battery 115 is being charged by the current flowing through battery 115;
Step 420: The controller circuit 205 calculates or derives the internal resistance R_INT of battery 115 according to the results sensed by the sensor circuit 100 and the current flowing through battery 115;
Step 425: The controller circuit 205 dynamically adjusts maximum voltage threshold or minimum voltage threshold by referring to the internal resistance R_INT of battery 115 and the current flowing through battery 115; and
Step 430: End.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A method for adjusting a voltage threshold for a battery (115) being connected to a portable device, the battery (115) is being used for providing energy to the system operating on the portable device, comprising:
dynamically measuring an internal resistance (R_INT) of the battery (115); and
dynamically adjusting the voltage threshold according to the internal resistance (R_INT) of the battery (115) and a current (IBAT) flowing through the battery (115),
**characterized in that**
the voltage threshold is configured as a target minimum voltage threshold that can be provided for a system operating on the portable device, wherein the target minimum voltage threshold is indicating the system to shut down to protect the battery.

2. The method of claim 1, wherein the step of dynamically measuring the internal resistance (R_INT) of the battery (115) comprises:
measuring an external voltage level of the battery (115) for a first time to generate a first result and measuring a charging current to be provided to the battery (115), wherein the charging current is a substantially constant charging current under a constant current charging mode for the battery (115);
measuring the external voltage level for a second time to generate a second result when the charging current is being provided to the battery (115); and
estimating the internal resistance (R_INT) of the battery (115) according to the first result, the second result, and the charging current.

3. The method of claim 1, wherein preferably the step of dynamically adjusting the voltage threshold according to the internal resistance (R_INT) of the battery (115) and the current flowing through the battery (115) comprises:
dynamically adjusting the target minimum voltage threshold according to the internal resistance (R_INT) of the battery (115) and the current (IBAT) flowing through the battery (115), to early protect the battery (115).

4. An apparatus for adjusting a voltage threshold for a battery (115) being connected to a portable device, the battery (115) is being used for providing energy to the system operating on the portable device, comprising:
a sensor circuit (100), for dynamically measuring an internal resistance (R_INT) of the battery (115); and
a controller circuit (205), coupled to the sensor circuit (100), for dynamically informing a system operating on the portable device to adjust the voltage threshold according to the internal resistance (R_INT) of the battery (115) and a current (IBAT) flowing through the battery (115),
**characterized in that**
the voltage threshold is configured as a target minimum voltage threshold that can be provided for the system operating on the portable device, wherein the target minimum voltage threshold is indicating the system to shut down to protect the battery.

5. The apparatus of claim 4, wherein the sensor circuit (100) is arranged to measure an external voltage level of the battery (115) for a first time to generate a first result and measure a charging current to be provided to the battery (115); the sensor circuit (100) is arranged for measuring the external voltage level for a second time to generate a second result when the charging current is being provided to the battery (115); and, the sensor circuit (100) is arranged for estimating the internal resistance (R_INT) of the battery (115) according to the first result, the second result, and the charging current,
wherein the charging current is a substantially constant charging current under a constant current charging mode for the battery (115).

6. The apparatus of claim 4, wherein preferably the controller circuit (205) is arranged for informing the system to dynamically adjust the target minimum voltage threshold according to the internal resistance (R_INT) of the battery (115) and the current flowing through the battery (115), to early protect the battery (115).

## Patentansprüche

1. Verfahren zum Einstellen eines Spannungsschwellenwerts für eine Batterie (115), die mit einer tragbaren Vorrichtung verbunden ist, wobei die Batterie (115) zum Bereitstellen von Energie an das System, das in der tragbaren Vorrichtung arbeitet, verwendet wird, umfassend:
dynamisches Messen eines Innenwiderstands (R_INT) der Batterie (115); und
dynamisches Einstellen des Spannungsschwellenwerts gemäß dem Innenwiderstand (R_INT) der Batterie (115) und einem Strom (IBAT), der durch die Batterie (115) fließt,
**dadurch gekennzeichnet, dass**
der Spannungsschwellenwert als ein Ziel-Minimalspannungschwellenwert konfiguriert ist, welcher für ein System, das in der tragbaren Vorrichtung arbeitet, bereitgestellt werden kann, wobei der Ziel-Minimalspannungschwellenwert dem System anzeigt, abzuschalten, um die Batterie zu schützen.

2. Verfahren gemäß Anspruch 1, wobei der Schritt des dynamischen Messens des Innenwiderstands (R_INT) der Batterie (115) umfasst:
Messen eines externen Spannungspegels der Batterie (115) für ein erstes Mal, um ein erstes Ergebnis zu generieren, und Messen eines Ladestroms, der an die Batterie (115) bereitzustellen ist, wobei der Ladestrom ein im Wesentlichen konstanter Ladestrom in einem Konstantstromlademodus für die Batterie (115) ist;
Messen des externen Spannungspegels für ein zweites Mal, um ein zweites Ergebnis zu generieren, wenn der Ladestrom an die Batterie (115) bereitgestellt wird; und
Berechnen des Innenwiderstands (R_INT) der Batterie (115) gemäß dem ersten Ergebnis, dem zweiten Ergebnis und dem Ladestrom.

3. Verfahren gemäß Anspruch 1, wobei der Schritt des dynamischen Einstellens des Spannungsschwellenwerts gemäß dem Innenwiderstand (R_INT) der Batterie (115) und dem Strom, der durch die Batterie (115) fließt, bevorzugt umfasst:
dynamisches Einstellen des Ziel-Minimalspannungsschwellenwerts gemäß dem Innenwiderstand (R_INT) der Batterie (115) und dem Strom (IBAT), der durch die Batterie (115) fließt, um die Batterie (115) früh zu schützen.

4. Vorrichtung zum Einstellen eines Spannungsschwellenwerts für eine Batterie (115), die mit einer tragbaren Vorrichtung verbunden ist, wobei die Batterie (115) zum Bereitstellen von Energie an das System, das in der tragbaren Vorrichtung arbeitet, verwendet wird, aufweisend:
eine Sensorschaltung (100) zum dynamischen Messen eines Innenwiderstands (R_INT) der Batterie (115); und
eine Steuerungsschaltung (205), die mit der Sensorschaltung (100) verbunden ist, zum dynamischen Informieren eines Systems, das in der tragbaren Vorrichtung arbeitet, den Spannungsschwellenwert gemäß dem Innenwiderstand (R_INT) der Batterie (115) und einem Strom (IBAT), der durch die Batterie (115) fließt, einzustellen,
**dadurch gekennzeichnet, dass**
der Spannungsschwellenwert als ein Ziel-Minimalspannungschwellenwert konfiguriert ist, welcher für das System, das in der tragbaren Vorrichtung arbeitet, bereitgestellt werden kann, wobei der Ziel-Minimalspannungschwellenwert dem System anzeigt, abzuschalten, um die Batterie zu schützen.

5. Vorrichtung gemäß Anspruch 4, wobei die Sensorschaltung (100) eingerichtet ist, einen externen Spannungspegel der Batterie (115) für ein erstes Mal zu messen, um ein erstes Ergebnis zu generieren, und einen Ladestrom, der an die Batterie (115) bereitzustellen ist, zu messen; die Sensorschaltung (100) zum Messen des externen Spannungspegels für ein zweites Mal eingerichtet ist, um ein zweites Ergebnis zu generieren, wenn der Ladestrom an die Batterie (115) bereitgestellt wird; und die Sensorschaltung (100) zum Berechnen des Innenwiderstands (R_INT) der Batterie (115) gemäß dem ersten Ergebnis, dem zweiten Ergebnis und dem Ladestrom eingerichtet ist,
wobei der Ladestrom ein im Wesentlichen konstanter Ladestrom in einem Konstantstromlademodus für die Batterie (115) ist.

6. Vorrichtung gemäß Anspruch 4, wobei die Steuerungsschaltung (205) bevorzugt zum Informieren des Systems eingerichtet ist, den Ziel-Minimalspannungschwellenwert gemäß dem Innenwiderstand (R_INT) der Batterie (115) und dem Strom, der durch die Batterie (115) fließt, dynamisch einzustellen, um die Batterie (115) früh zu schützen.

## Revendications

1. Procédé pour régler un seuil de tension pour une batterie (115) étant connectée à un dispositif portable, la batterie (115) est utilisée pour fournir de l'énergie au système fonctionnant sur le dispositif portable, comprenant :
mesurer de manière dynamique une résistance interne (R_INT) de la batterie (115) ; et
régler de manière dynamique le seuil de tension en fonction de la résistance interne (R_INT) de la batterie (115) et du courant (IBAT) traversant la batterie (115),
**caractérisé en ce que**
le seuil de tension est configuré en tant que seuil de tension minimal cible qui peut être fourni à un système fonctionnant sur le dispositif portable, dans lequel le seuil de tension minimal cible indique au système de s'éteindre afin de protéger la batterie.

2. Procédé de la revendication 1, dans lequel l'étape de mesure dynamique de la résistance interne (R_INT) de la batterie (115) comprend :
mesurer un niveau de tension externe de la batterie (115) pendant un premier temps pour générer un premier résultat et mesurer un courant de charge à fournir à la batterie (115), où le courant de charge est un courant de charge sensiblement constant dans un mode de charge en courant constant pour la batterie (115) ;
mesurer le niveau de tension externe pendant un deuxième temps pour générer un deuxième résultat lorsque le courant de charge est fourni à la batterie (115) ; et
estimer la résistance interne (R_INT) de la batterie (115) en fonction du premier résultat, du deuxième résultat et du courant de charge.

3. Procédé de la revendication 1, dans lequel préférentiellement l'étape consistant à régler de manière dynamique le seuil de tension en fonction de la résistance interne (R_INT) de la batterie (115) et du courant traversant la batterie (115) comprend :
régler de manière dynamique le seuil de tension minimal cible en fonction de la résistance interne (R_INT) de la batterie (115) et du courant (IBAT) traversant la batterie (115), afin de protéger rapidement la batterie (115).

4. Appareil pour régler un seuil de tension pour une batterie (115) étant connectée à un dispositif portable, la batterie (115) étant utilisée pour fournir de l'énergie au système fonctionnant sur le dispositif portable, comprenant :
un circuit de détection (100), pour mesurer de manière dynamique une résistance interne (R_INT) de la batterie (115) ; et
un circuit de commande (205), couplé au circuit de détection (100) pour informer de manière dynamique un système fonctionnant sur le dispositif portable de régler le seuil de tension en fonction de la résistance interne (R_INT) de la batterie (115) et d'un courant (IBAT) traversant la batterie (115),
**caractérisé en ce que**
le seuil de tension est configuré en tant que seuil de tension minimal cible qui peut être fourni au système fonctionnant sur le dispositif portable, dans lequel le seuil de tension minimal cible indique au système de s'éteindre afin de protéger la batterie.

5. Appareil de la revendication 4, dans lequel le circuit de détection (100) est agencé pour mesurer un niveau de tension externe de la batterie (115) pendant un premier temps afin de générer un premier résultat et mesurer un courant de charge à fournir à la batterie (115) ; le circuit de détection (100) est agencé pour mesurer le niveau de tension externe pendant un deuxième temps afin de générer un deuxième résultat lorsque le courant de charge est fourni à la batterie (115) ; et, le circuit de détection (100) est agencé pour estimer la résistance interne (R_INT) de la batterie (115) en fonction du premier résultat, du deuxième résultat et du courant de charge,
dans lequel le courant de charge est un courant de charge sensiblement constant dans un mode de charge en courant constant pour la batterie (115).

6. Appareil de la revendication 4, dans lequel préférentiellement le circuit de commande (205) est agencé pour informer le système de régler de manière dynamique le seuil de tension minimal cible en fonction de la résistance interne (R_INT) de la batterie (115) et du courant traversant la batterie (115), afin de protéger rapidement la batterie (115).
